**Europäisches Patentamt**

**European Patent Office**

**Office européen des brevets**

(11) Publication number: **0 088 611**
**B1**

(12) **EUROPEAN PATENT SPECIFICATION**

(45) Date of publication of patent specification: **25.01.89**

(21) Application number: **83301183.6**

(22) Date of filing: **04.03.83**

(51) Int. Cl.⁴: **H 03 J 9/06, H 04 B 1/08**

(54) **Removable electronic control device in an apparatus such as a television set or a video recorder.**

(30) Priority: **04.03.82 JP 31238/82 u**
**04.03.82 JP 31239/82 u**
**18.05.82 JP 73005/82 u**
**18.05.82 JP 73006/82 u**
**18.05.82 JP 73007/82 u**
**20.05.82 JP 74664/82 u**

(43) Date of publication of application:
**14.09.83 Bulletin 83/37**

(45) Publication of the grant of the patent:
**25.01.89 Bulletin 89/04**

(84) Designated Contracting States:
**DE FR GB**

(56) References cited:
**FR-A-2 368 096**
**FR-A-2 377 731**
**FR-A-2 423 103**
**FR-B-2 397 115**

(73) Proprietor: **SHARP KABUSHIKI KAISHA**
**22-22 Nagaike-cho Abeno-ku**
**Osaka 545 (JP)**

(72) Inventor: **Okazaki, Masanori**
**5-9 Asaka 1-chome**
**Ohtawara-shi Tochigi-ken (JP)**

(74) Representative: **Wright, Peter David John et al**
**R.G.C. Jenkins & Co. 26 Caxton Street**
**London SW1H 0RJ (GB)**

Courier Press, Leamington Spa, England.

## Description

The present invention relates to an electronic apparatus, e.g. a television set, and more particularly to such an apparatus which can be operated by a remote control unit.

The present invention is particularly concerned with a television set in which a control unit, which may have a channel selecting knob and a volume control knob, is removably accommodated within the casing or cabinet of the television set.

In a conventional television set, an operating panel having a number of different control knobs or the like, is fixed into the front surface of the cabinet, and the knobs and the like are permanently exposed to the front of the cabinet. This permanent exposure of the knobs and switches tends to make the external appearance of the television set somewhat unattractive, and certainly does not conform with modern trends in design which favour simplicity in outward appearance.

FR-A-2423103 discloses a television set provided with a housing pivotally mounted to the casing, the housing accommodating a removable control unit. In this known arrangement the housing pivots between an open, outwardly inclined position permitting insertion and removal of the control unit, and a closed or retracted position in which the control unit is housed within the casing. In the closed position of the housing the control buttons of the control unit are exposed through a front aperture in the housing, and control signals from the control unit can reach a receiving cell in the casing. Control signals from the control unit in the housing cannot reach the cell in the open position.

According to the present invention there is provided a television set in which a housing member accommodates a control unit which can be operated by a user to control the television set, the housing member being mounted in a recess of the casing of the television set so that it can be rotated relative to the casing from a first, closed position to a second, open position in which the control unit can be removed from the housing member, characterised in that only in said second, open position of the housing member is the control unit accommodated therein presented for access by the user and operable for controlling the television set.

This arrangement therefore affords the operational advantages associated with a removable remote control unit and also satisfies the requirements for simplicity of external appearance of the television casing.

The control unit preferably includes a control signal transmitter, a control signal receiver being mounted inside said casing, said housing member including signal reflecting means in tubular form which is adapted to direct a said control signal transmitted from said control unit accommodated in said housing member to said control signal receiver in said open position of the housing member.

In each of the several embodiments described herein there is provided means for releasably latching the housing member in the closed position.

The present invention will be better understood from the detailed description given hereinbelow and the accompanying drawings which are given by way of illustration only, and thus are not limitative of the present invention and wherein:

Fig. 1 is a cutaway front elevation of a conventional remote control transmitter apparatus;

Fig. 2 is a sectional plan drawing of one embodiment of a channel selecting control unit in a television set according to the present invention;

Fig. 3 is a sectional view taken on the line A-A' in Fig. 2 in the direction of the arrows;

Fig. 4 is another sectional view, showing the control unit housing in its open position;

Fig. 5 is a rear elevational view of another embodiment of a channel selecting control unit housing in a television set according to the present invention;

Fig. 6 is a sectional plan view of the embodiment shown in Fig 5.

Fig. 7 is a sectional view taken on the line B-B' in Fig. 5 in the direction of the arrows;

Fig. 8 is a sectional view taken on the line C-C' in Fig. 5 in the direction of the arrows;

Fig. 9 is a sectional view taken on the line D-D' in Fig. 5 in the direction of the arrows;

Fig. 10 is a sectional plan view of still another channel selecting control unit housing in a television set according to the present invention;

Fig. 11 is a rear view of the control unit housing shown in Fig. 10;

Fig. 12 is a sectional side elevational view of the control unit housing shown in Figs 10 and 11;

Fig. 13 is a sectional plan view of still another embodiment of a control unit housing in a television set according to the present invention;

Fig. 14 is a sectional view taken on the line E-E' in Fig. 13 in the direction of the arrows;

Fig. 15 is another sectional view of the control unit housing of Fig. 13 in the open condition of the housing;

Fig. 16 is a cutaway plan view of a further embodiment of a control unit housing in a television set according to the present invention;

Fig. 17 is a rear view of the control unit shown in Fig 16.

Fig. 18 is a sectional view taken on the line of F-F' in Fig. 17 in the direction of the arrows;

Fig. 19 is a sectional view taken on the line G-G' in Fig, 17 in the direction of the arrows;

Fig. 20 is a cutaway plan view of a further embodiment of a control unit housing in a television set according to the present invention;

Fig. 21 is a sectional view taken on the line H-H' in Fig. 20 in the direction of the arrows;

Fig. 22 is a sectional view taken on the line I-I' in Fig. 20 in the direction of the arrows: and

Fig. 23 and Fig. 24 are enlarged views of a cam used in the embodiment of Figs. 20 to 22.

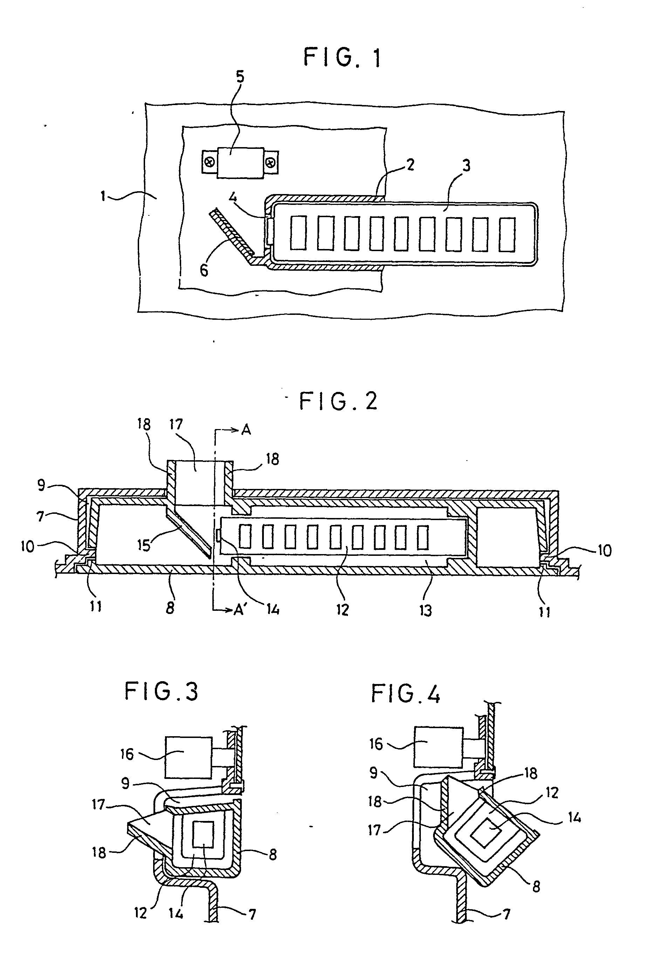

Figure 1 shows a known arrangement in which a remote control unit for the remote control over channel selection and volume includes, a transmitting device and is accommodated in the main body of the television set.

The front face of a television set casing, or cabinet 1 includes a transmitter storage recess 2, and an aperture 4 is provided in one side surface of this recess 2, in order to admit a signal from a transmitter 3 into the main body of the cabinet. A reflection plate 6 is installed in the vicinity of this aperture 4, in order to reflect the signal toward a receiving device 5 fixed in a position above the transmitter 3, and the signal from the transmitter 3 is reflected by the reflecting plate 6, and directed to the receiving device 5.

However, in this known apparatus, when the signal is transmitted by the reflecting plate 6, it becomes diffused and there is the fear that a large transmission loss will cause an error in operation.

The embodiments of the present invention alleviate the above problem, and are able reliably to transmit. The remote control unit is stored in a housing member, this housing member being rotatably mounted in the casing of the television set, so that when the television set is not being used, the housing member is closed and the control unit is stored inside the casing.

The following is a detailed explanation of one embodiment of the present invention, with reference to Fig. 2 to Fig. 4.

Fig. 2 is a sectional plan view of one embodiment of a channel selecting control unit in a television set according to the present invention.

Fig. 3 is a sectional view taken on the line A-A' in Fig. 2 in the direction of the arrows;

Fig. 4 shows the embodiment of Fig. 3 with the housing member rotated to its open position, so that the remote control unit is presented for access by the under in that it can either be taken out for remote operation, or can be operated while stores as a channel selector.

A recess in the front face of the cabinet 7 of the television set stores a housing member 8. The recess 9 is shaped as shown in Fig. 2 and Fig. 3. Projections are provided in the sides of the recess to engage apertures 11 provided in the sides of the housing member 8, allowing the housing member 8 to be rotatably mounted.

An operating panel face of the housing member 8 includes a concave section 13, in which a remote control unit 12 is stored, and a reflecting panel 15 is provided in the vicinity of a signal generating section 14 of the remote control unit 12 to reflect the signal. A tubular section 17 is provided in the rear wall of the housing member 8 to transmit the signal to a receiving unit 16, and the inner surface of the tubular section comprises reflection plates 18.

The housing member 8 is usually in its closed position in which it is stored in the interior of the cabinet 7, as shown in Fig. 3; in use, as shown in Fig. 4, it is in its open, forwardly rotated position for operation of the control unit. The remote control unit 12 can be removed from the housing member 8, and is operable for transmission of control signals to the receiver 16 from a remote position.

As outlined above, in this embodiment of the present invention, the path for the signals is surrounded by the tubular shape of the reflection plates 18 and 18'. Because the dispersion of the signals can be prevented by the tubular construction of the reflection plate 18, the signals can be reliably transmitted. Furthermore, since the housing member 8 is rotatably installed in the cabinet, when the control unit 12 is not being used, the member 8 can be stored in the interior of the cabinet, the outer surface of the cabinet being thereby made flat.

Next follows an explanation of another embodiment of the present invention.

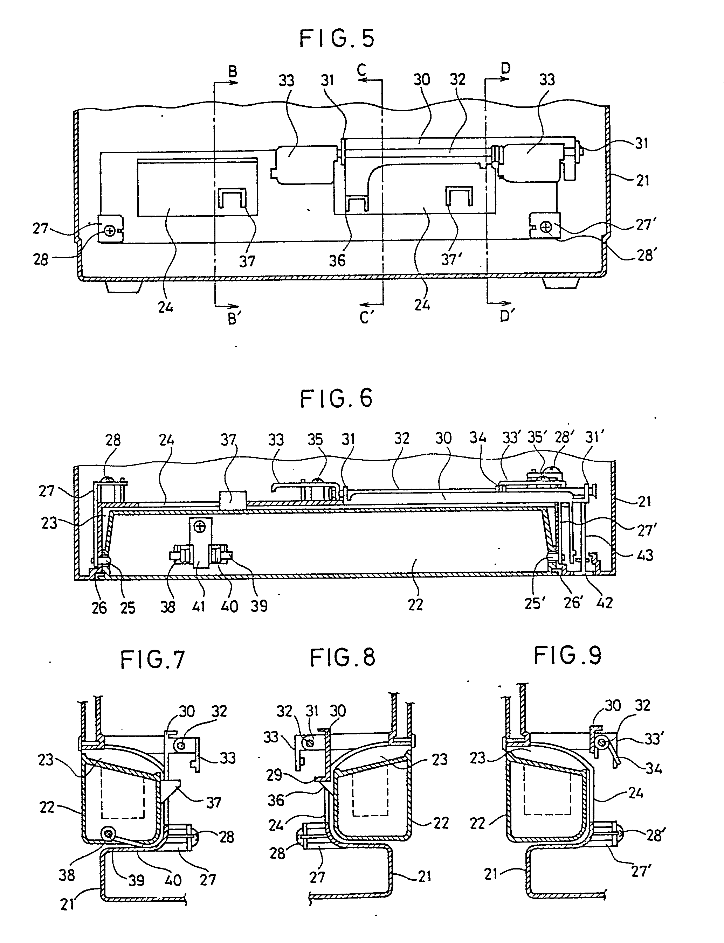

Fig. 5 is a back elevational view of another channel selecting control unit housing in a television set according to the present invention.

Fig. 6 is a sectional plan view of the embodiment shown in Fig 5.

Fig. 7 is a sectional view taken on the line B-B' in Fig. 5 in the direction of the arrows.

Fig. 8 is a sectional view taken on the line C-C' in Fig. 5 in the direction of the arrows.

Fig. 9 is a sectional view taken on the line D-D' in Fig. 5 in the direction of the arrows.

A recess 23 for storing a housing member 22 is formed in the front surface of a cabinet 21 of a television set. In the back surface of the recess 23, a plurality of apertures 24 and 24' are provided. Into apertures 26, 26' in the sidewalls of the housing member 22 are inserted engagement members 25 and 25'.

L-shaped leaf springs 27 and 27' are mounted in the vicinity of the both ends of the storage section 23 and carry the cylindrical engagement members 25 and 25'. The springs 27 and 27' are affixed to the cabinet 21 by screws 28 and 28' from the outside rear surface of the recess 23.

The housing member 22 is kept stores. A lock plate 30 is formed with a hook 29, and bent shaft-attaching sections 31 and 31', through which a shaft 32 extends.

The shaft 32 is mounted by means of two pressure plates 33 and 33' in order to mount the lock plate 30 relative to the cabinet 21, and a coil 34 is attached to the shaft so as to urge the lock plate 30 in the forward direction.

The pressure plates 33 and 33' are attached to the outside of the recess 23 with screws 35 and 35'.

A projection 36 is provided on the rear surface of the housing member 22, in the position opposing the hook 29 provided on the lock plate 30, and stoppers 37 and 37' are formed at locations to position the housing member 22 when it is rotated to its open position.

An aperture 38 is formed in the lower wall of the housing member 22, and a spring 40 mounted on a shaft 39, is located in part of the aperture 38 by means of an angle bar 41. The spring 40 is formed with a U-shaped connecting member (not shown in the drawings) having coil-wound parts at both ends thereof.

A pressure plate 42 is provided in the front surface of the cabinet 21, adjacent the recess 23 and a rib 43 projects from the rear of the pressure plate 42 to a point adjacent the lock plate 30.

The remote control transmitter is provided in the upper surface of the operating panel of the housing member 22.

When the housing member 22 is stored in the recess 23, by pressing the housing member 22 into the recess 23, the engagement members 25 and 25' are pushed back by means of the elasticity of the leaf springs 27 and 27', and on further pressing the housing member 22, the engagement member 25 and 25' are inserted into the apertures 26 and 26' provided in the both sides of the housing member 22, whereby the housing member 22 is rotatably secured in the recess 23. In this way, when the housing member 22 attached to the cabinet 21 is to be opened, the pressure plate 42, is pushed, and this causes the lock plate 30 to be pressed in the rearward direction by the rib 43, and the hook 29 of the lock plate 30 is separated from the projection 36, and with the aid of the resistance of the spring 40 the housing member 22 is made to rotate forwardly until it is engaged at an appropriate position by the stoppers 37 and 37'. Also, when being closed, the housing member 22 is pressed by hand, and upon its rotation, the projection 36 becomes engaged by the hook 29, and the housing member 22 is again locked in its closed position.

In this way, the housing member 22 is releasably latched in its closed position in the casing of the television set in the above embodiment, and the outside design of the cabinet can be made flat.

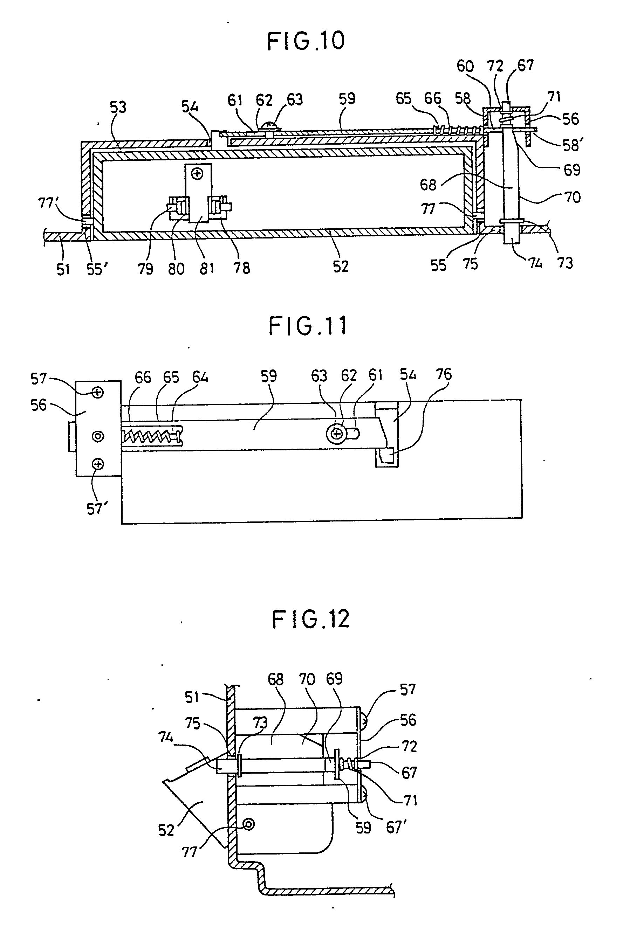

The following is a description of a further embodiment of the present invention, as illustrated in Fig. 10 to Fig. 12.

A recess 53 in the front face of a television set cabinet 51 stores a housing member 52. An elongated aperture 54 is formed in the recess 53. The recess 53 includes engagement members 55 and 55' to fix the housing member 52 at its opposite sides. A U-shaped angle bar 56 on the outer side of the recess 53 is installed on the cabinet 51 by means of screws 57 and 57', and a slide plate 59 is inserted into apertures 58 and 58' provided on both sides of the angle bar 56. A slide aperture 60 is provided in the slide plate 59 between the sides of the angle bar 56. A fixed aperture 61 in the slide plate 59 has an oval shape and a screw 63, via a washer 62, protrudes through the aperture 61, and is attached to the back surface of the recess 53. The slide plate 59 is provided with an aperture 65 having a projection 64, and a coil spring 66 is attached to the projection 64 with its other end attached to the angle bar 56. Furthermore, in order to make the slide plate 59 slide, a shaft 70 is formed with an inclined section 69 between a small diameter section 67 and a large diameter section 68. A spring coil 71 is attached to the small diameter section of the shaft 70 which protrudes through the aperture 60 provided in the slide plate 59, and then protrudes through the aperture 72 provided on the back face of the angle bar 56. A push button 74 having a brim 73 is attached to the forward end of the large diameter section 68 of the shaft 70, and the push button 74 projects in a forward direction from an aperture 75 provided in the cabinet 51.

On the rear surface of the housing member 52, there is provided a stopper 76 which projects through the aperture 54 provided in the rear wall of the recess 53, and at opposite sides of the operating section 52, there are provided, rotating spindles 77 and 77' which when the housing member is attached to the cabinet 51 define the axis of rotation. Also, an aperture 78 is formed on the bottom surface of the housing member 52, and a spring 80 mounted on a shaft 79 is located in part of the aperture 78 by a fixed plate 81. The spring 80 is formed with a U-shaped connecting member (not shown on the drawings), having coil-wound parts at both ends.

When the housing member 52 is located in the recess 53, the rotating spindles 77 and 77' provided at the sides of the housing member are inserted into the engagement openings 55 and 55' provided in the sides of the recess storage section 53.

When the housing member 52 of the embodiment of the present invention constructed in the manner described, is to be opened pushing of the push button 74 causes the inclined section 69 of the shaft 70 to move the slide plate 59. Because of this, the engagement between the stopper 76 and the slide plate 59 is released and the housing member 52 is made to rotate by the spring 80 provided on the bottom surface of the housing member 52. Then, on rotating to a prescribed position, the stopper 76 maintains the housing member 52 in an open state as the stopper 76 engages the cabinet 51. Next, when the housing member 52 is pushed closed, the slide plate 59 is made to slide against the spring bias on pushing the front surface of the housing member 52, and during further rotation of the latter, the slide plate 59 is urged by the spring 66 to slide into contact with the stopper 76, whereby the housing member 52 is maintained in its closed state.

In this way, on the television set according to this embodiment of the present invention, because the direction of the rotation of the housing member 52, and the action direction of the slide member 59 are deviated by 90 degrees, the housing member 52 will not accidentally open even if it is subjected to shock.

In order to store the remote control unit in the housing member 52 of this embodiment of the present invention, a U-shaped recess is provided in the inner side of the operating panel.

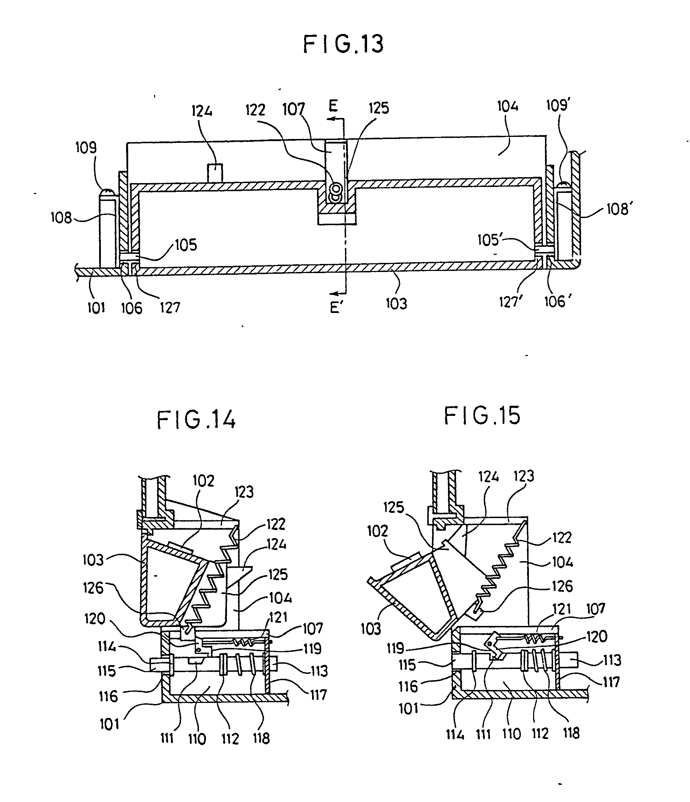

The following is an explanation of another embodiment of the present invention which is illustrated in Fig. 13 to Fig. 15.

A recess 104 in the front face of a television set cabinet 101 stores a housing member 103 which has an operating panel provided with a concave storage section accommodating a remote control unit, such unit including a channel changing bottom 102 or the like. The housing member 103 is located on both side faces of the recess 104 by means of coaxial engagement members 105 and 105′ inserted into respective apertures 106 and 106′. A cut 107 is provided on the back face of the recess 104. Then, the engagement members, each 105 and 105′ attached to one end of a respective metal fitting 108 and 108′, are inserted into the apertures 106 and 106′, from the outside of the recess 104, and the metal fittings 108 and 108′ are affixed to the cabinet 101 by screws 109 and 109′. A rotating means 110 for rotating the operating section 103, is provided in the button of storage section 104. The rotating means 110 comprises a shaft 113 provided with a detent 111 and a brim 112, and on the front end of the shaft 113 there is installed a push button 115 having a brim 114. The push button 115 protrudes in a forward direction through an aperture 116 provided in the front face of the cabinet 101, and the other end of the shaft 113 at the same time projects through an aperture (not shown on the drawings) provided in a fixed plate 117. A coil spring 118 is attached between the fixed plate 117 and the brim 112, normally urges the shaft so as to project the push button 115 in a forward direction. An L-shaped engagement member 120 having a projection 119, is rotatably provided in the vicinity of the shaft 113, and the projection 119 is urged by a spring 121 against the upper surface of the shaft 113. Furthermore, a member 123 fixed into the upper side of the recess 104 fixes one end of a spring 122 for rotating the housing member 103.

The spring 122 is provided at the rear of the housing member 103, and a cut-out 125 is provided in the central section of the back surface of the housing member 103 for accommodating the spring 122. On the bottom surface, a projection 126, to which the other end of the spring 122 is attached, is provided in the vicinity of the cut-out 125. In both side walls of the housing members apertures 127 and 127′ receive the respective engagement members 105 and 105′ which act as a fulcrum for rotation.

When the housing member 103 is to be located in the recess 104, the engagement members 105 and 105′ are pushed back by the action of pushing the housing member 103 into the recess 104, against the resilience of the metal fittings 109 and 109′. On further pushing the housing member, the engagement members 105 and 105′ become inserted into the apertures 127 and 127′ provided in the side walls of the housing member 103, which is then able to rotate freely in the cabinet 101. The spring 122 is installed in the space between the fixed member 123 provided on the upper side of the recess 104 and the projection 126 provided on the lower surface of the housing member 103.

When the housing member 103 is to be opened, pressing of the push button 115, causes the projection 119 provided on the engagement member 120 to protrude into the detent 111 provided on the shaft 113 by allowing the engagement member 120 to be turned by the action of the spring 121. Because of this, the engagement of the projection 126 provided on the lower surface of the housing member 103 is released, so that the housing member 103 is rotated by the spring 122 until the stopper 124 engages the cabinet 101 whereafter the housing member 103 is held open by such engagement with the cabinet 101, Also, when the housing member 103 is to be closed, the projection 126 is again brought into engagement with engaging member 102 by pushing the front surface of the housing member 103.

Accordingly, in the abovementioned embodiment, the opening and closing operations of the apparatus can be easily enabled, and because the parts can be miniaturized, they can be modified so that there is no worry about causing unsatisfactory operation.

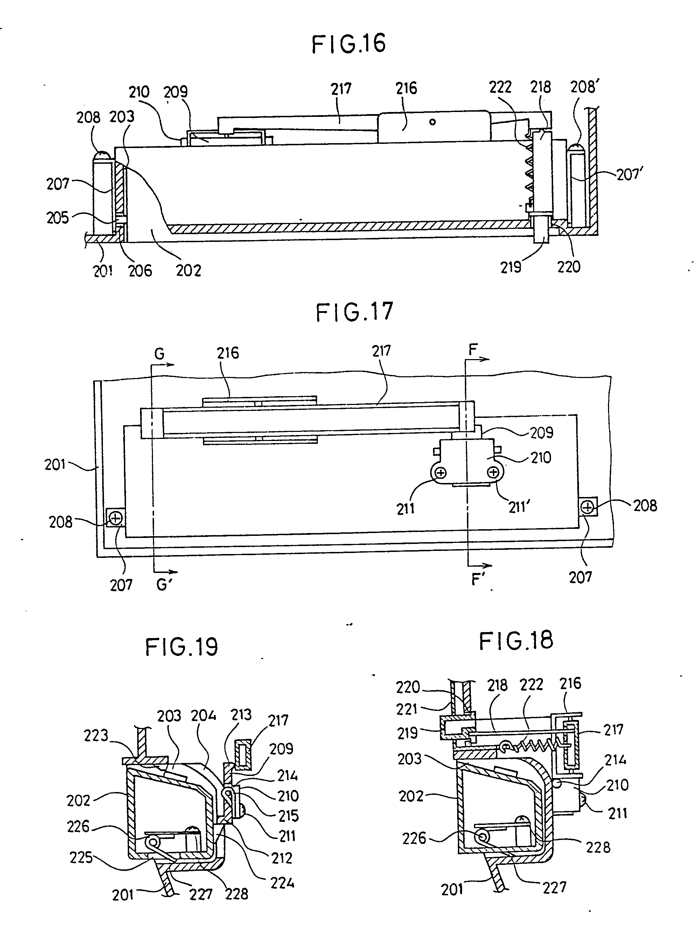

The following is an explanation of still another embodiment of the present invention which is illustrated in Fig. 16 to Fig 19.

First, a recess 203 which stores a housing member 202 is formed in the front face of a television set cabinet 201. An elongated aperture 204 is provided on the back surface of the recess 203, and also engagement members 205 and 205′ are provided which fit into apertures 206 and 206′. Resilient L-shaped metal members 207 and 207′ each having one of the cylindrical engagement members 205 and 205′ attached at one end, are attached to the cabinet 201 by screws 208 and 208′ on the outside surface of the recess 203, and the engagement members 205 and 205′ are made to protrude through the apertures 206 and 206′ into the recess 203. A lock plate 209 disposed behind the rear wall of the recess 203 for latching the housing member 202 in a stored state, is rotatably attached to a plate 210 fixed by screws 211 and 211′. An engagement portion 212 is provided on the lower end of the front surface of the lock plate 209 to latch the operating section 202, and a projection 213 is provided on the upper end of the back surface of the lock plate 209. A spring 215 is mounted on a shaft section 214 and is arranged to urge the engagement portion 212 in the forward direction. Furthermore, a teetering plate 217 mounted on a U-shaped angle bar 216 is provided on the back outside face of the recess 203. One end of the teetering plate 217 faces the projection 213 of the lock plate 209, and a slide plate 218 is attached to the other end. A push button 219 attached to the leading end of the slide plate 218 normally projects forwardly through an aperture 220 provided on the front face of the cabinet 201, the slide plate forwardly biased by a spring 222 attached between one end of the teetering plate 217 and the end of a bent facia plate 221 provided on the inside of the front surface of the cabinet 201. Also, a convex engagement member 223 is provided on the inside upper surface of the recess 203, to stop the housing member 202 in a prescribed position when it is opened. On the other hand, on the rear surface of the housing member 202, there is provided a projection 224 which projects through the elongated aperture 204 in the recess wall 203, and apertures (not shown on the drawings) are provided in both side surfaces, penetrated by the engagement members 205 and 205'. Also, an aperture 225 is provided in the bottom surface of the housing member 202, and a spring 227 attached to a shaft 226 is secured by an angle bar 228.

In the channel selecting panel holder constructed in the manner outlined above, when the housing member 202 is to be opened pushing of the push button 219 causes the slide plate 218 to rotate the teetering plate 217 so that its end adjacent the lock plate moves in the forward direction. Because of this, the lock plate 209 is pushed and rotated, and the engagement member 212 is separated from the projection 224, so that the housing member 202 is permitted to rotate by the action of the spring 227. The projection 224 prevents further rotation of the housing member 202 when it has reached its prescribed open position by engagement with the convex engagement member 223. To close the housing member, pushing on the front surface thereof causes it to rotate such engagement causing the operating section 202 to be maintained in its closed state.

Accordingly, in the above embodiment of the present invention, by varying the length of the teeter plate 217 and the position of the fulcrum, the position of the push button 219 can be freely selected, and at the same time the pressure required to activate the push button 219 can be easily adjusted.

A concave storage section is provided in the inside upper surface of the operating panel of the above housing member, and a remote control unit is stored therein.

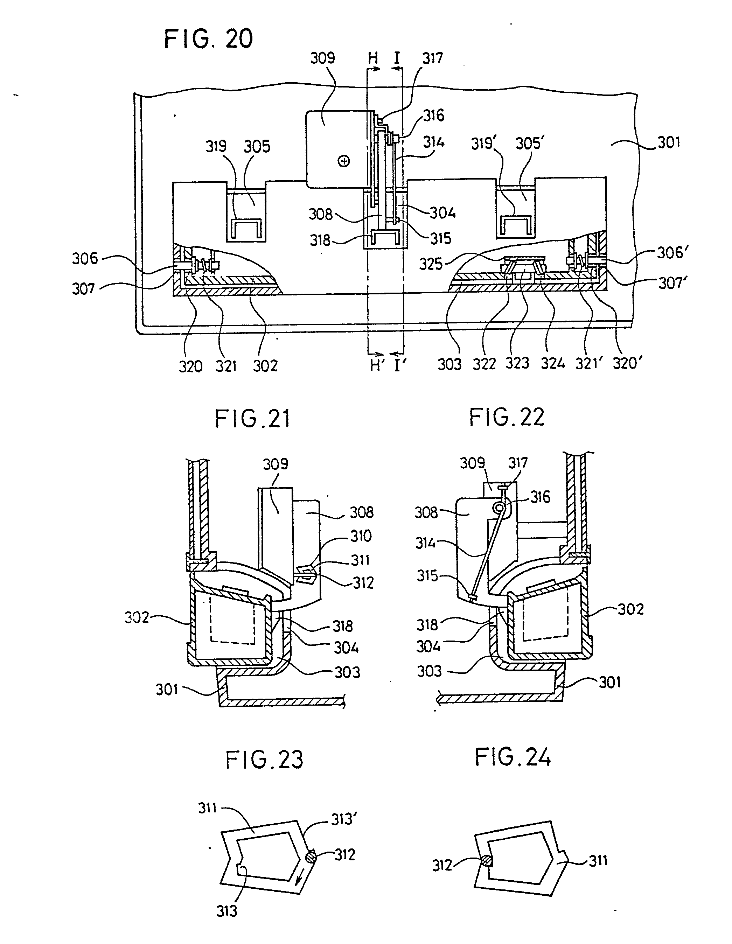

The following is an explanation of another embodiment of the present invention which is illustrated in Fig. 20 to Fig. 24.

First, a recess 303 which stores a housing member 302 is formed in the front face of a television set cabinet 302, and, in the back surface of the recess 303, a plurality of apertures 304 and 305 and 305' are provided, and engagement members 306 and 306' penetrate apertures 307 and 307' in both side surfaces of the recess 303. In addition, in the aperture of the back side surface of the recess 303, a U-shaped lock plate 308 is rotatably secured by an angle bar 309. A heart cam 310 is provided in one side surface of the lock plate 308, and an L-shaped guide pin 312 protrudes through the angle bar 309 and penetrates a slot 311 formed in the heart cam 310. Engagement portions 313 and 313' are provided at appropriate positions of the slot 311, as shown in Fig. 23, in order to prevent the guide pin 312 from reversing its direction of travel around the slot; the guide pin slides in the direction of the arrow. Also, on the other side of the lock plate 308, there is provided a projection 315 onto which is hooked one end of a spring 314 which is mounted on a shaft 316 which is positioned on the axis of rotation of the lock plate 308 relative to the angle bar 309. The other end of the spring 314 is hooked onto a projection 317 provided on the angle bar 309, and the spring acts so as to urge the lower end of the lock plate 308 normally in a forward direction.

On the other hand, a projection 318 for engaging the lock plate 308 is provided on the back surface of the housing member 302 in the location of the aperture 304. Also, stoppers 319 and 319' are provided in the region of other apertures 305 and 305' for maintaining the housing member in a prescribed open position. Also, apertures 320 and 320' are provided on both sides of the housing member 302, and the engagement members 306 and 306' are biased from the inner side of the housing member 302 by springs 321 and 321' outwardly through these apertures 320 and 320'. Furthermore, an aperture 322 is formed in the bottom surface of the housing member 302, and a spring 324 attached to a shaft 323 is located in the aperture 322 by means of a fixed member 325.

When the operating section 302 is to be stored in the recess 303, the engagement members 306 and 306' are pushed back into the inside of the housing member 302 by pushing the housing member 302 into the recess 303. On further pushing the housing member 302 into the recess 303, the engagement members 306 and 306' are made to project into the apertures 307 and 307' provided on the side of the recess 303, by the action of the springs 321 and 321'. The housing member 302 is thereby located and stored in the recess 303.

In the channel selecting panel holder constructed as outlined above, when the housing member 302 is to be opened, pressure applied to the front surface of the housing member 302 causes the guide pin 312 to move along the slot 311 as the lock plate 308 is rotated in the rearward direction and when the guide pin reaches the position illustrated in Fig. 24 it is held by the engagement portion 313. In this way the engagement between the lock plate 308 and the projection 318 is released, and the housing member 302 is made to rotate forwardly by the action o the spring 324. On forward rotation of the housing member to a prescribed open position, the stoppers 319 and 319' engage the cabinet 301 and thereby maintain the housing member 302 in its open condition. When the housing member 302 is to be closed, the application of pressure to the front surface of the housing member 302 causes the upper section of the rear face of the housing member 302 to engage the lock plate 308 whereby the guide pin 312 moves back to its original position as the lock plate 308 is rotated in the forward direction. Because of this, the lock plate 308 and the projection 318 are engaged, and the housing member 302 is maintained in its closed state.

In this way, in the abovementioned embodiment, a push button is not required for opening the housing member 302, and accordingly the design can be improved while the number of parts can be reduced, making it possible to reduce cost and eliminate worry about faulty operation.

Also, a concave storage section is provided for the accommodation of the remote control unit in the operating panel of the housing member 302.

In the above embodiments, the operating means for channel selection and the like in the television receiver is provided as a remote control unit which is removably stored in the housing member. When the remote control unit is to be used, the housing member is rotated, causing it to open in the forward direction, and the remote control unit can then be removed and utilized.

The present invention is not just applicable to television sets, but can also be used on video recorders and the like, and has a wide range of applications.

**Claims**

I. A electronic control device in an apparatus such as a television set or video recorder in which a housing member (8; 22; 52; 103; 202; 302) accommodates a control unit (12) which can be operated by a user to control the apparatus, the housing member being mounted in a recess (9; 23; 53; 104; 203; 303) of the casing (7; 21; 51; 101; 201; 301) of the apparatus so that it can be rotated relative to the casing from a first, closed position to a second, open position in which the control unit can be removed from the housing member, characterised in that only in said second, open position of the housing member is the control unit accommodated therein presented for access by the user and operable for controlling the television set.

2. A control device according to claim 1 wherein said control unit includes a control signal transmitter (14), and wherein a control signal receiver (16) is mounted inside said casing, said housing member including signal reflecting means (15, 17, 18) in tubular form which is adapted to direct a said control signal transmitted from said control unit accommodated in said housing member to said control signal receiver in said open position of the housing member.

3. A control device according to claim 1 or claim 2 wherein means, (56, 59, 66, 70, 71) is provided for releasably latching said housing member in said closed position, said latching means including a slide member (59) biased by a resilient means into engagement with a stopper means (76) on the housing member and latch release means (70, 71) for moving said slide member against the bias so as to release the engagement of said slide member with said stopper means.

4. A control device according to claim 3 wherein said latch release means includes a shaft member (70) having a first portion (74) manually actuable from outside the casing and a second portion (69) including an inclined surface which engages an edge of an aperture (60) in the slide member through which said shaft member projects, axial movement of said shaft member by manual actuation of said first portion causing the inclined surface to slide over said aperture edge thereby to move the slide member against said bias.

5. A control device according to claim 1 or claim 2 wherein means (56, 59, 66, 70, 71; 113, 118, 120, 121), is provided for releasably latching said housing member in said closed position, said latching means including an engagement member (59; 120) for engaging said housing member, and a shaft member (70; 113) biased by resilient means to engage said engagement member to hold it in engagement with said housing member, and wherein there is also provided means (80; 122) for rotating the housing member, when released from engagement by said engagement member upon movement of said shaft member, toward said open position, and a stopper means (76; 124) for retaining said housing member in said open position.

6. A control device according to claim 5 wherein said shaft member (113) has a first portion (115) manually actuable from outside said casing, and a second portion including a recess (111) formed at such a position that upon axial movement of the shaft member by manual actuation of the first portion, the engagement member (120) is caused to move so as to project into said recess, thereby effecting release of said housing member from said closed position.

7. A control device according to claim 1 or claim 2 wherein means (30, 42, 43; 113, 120; 209, 217, 218; 308, 310, 312) is provided for releasably latching said housing member in said closed position, said latching means including a locking member (30; 120; 209; 308) rotatably mounted in said casing and means (42, 43; 113; 217, 218; 310, 312) for controlling the rotation of said locking member, and wherein stopper means (37; 124; 224; 319) is provided for retaining said housing member in its open position when released by said locking member.

8. A control device according to claim 7 wherein said controlling means comprises a first displaceable member (218) manually actuable from outside the casing and a second, pivotable member (217) in engagement with said rotatable locking member (209) and with said first displaceable member, pivoting of said second member by manual actuation of said first member causing the locking member to rotate out of engagement with a projection (224) on said housing member (202).

9. A control device according to claim 7 wherein said controlling means is operable to cause the locking member (308) to release the housing member (302) from its closed position in response to rotational movement of said housing member produced by manual pressure applied to the front surface thereof.

10. A control device according to claim 9 wherein said controlling means comprises a cam (310) provided on said locking member, a cam follower pin (312) which engages in a closed cam slot (311) formed in said cam, and spring bias means (314) urging said locking member into engagement with the housing member in the closed position thereof, said cam slot having first and second cam follower engaging portions (313', 313), the engagement of said cam follower in said first engaging portion (313') holding the locking member in its position to latch the housing member in its closed position, wherein rotation of said locking member against the spring bias upon said rotational movement of the housing member by said manual pressure applied to said front surface thereof causes movement of the cam follower from said first toward said second engaging portion of said cam slot, engagement of said cam in said second engaging portion (313) holding said locking member in a non-latching position to permit rotation of said housing member (302) to said open position upon release of said manual pressure.

11. A control device according to any preceding claim, including spring bias (40; 80; 122; 227; 324) means arranged to bias said housing member rotationally toward said open position.

12. A control device according to any preceding claim wherein the electronic apparatus is a television set.

**Patentansprüche**

1. Ein elektronisches Steuergerät in Geräten wie einem Fernsehempfänger oder einem Videorecorder, bei dem ein Gehäuseteil (8;22;52;103;202;302) eine Steuereinheit (12) aufnimmt, die zur Steuerung des Gerätes durch einen Benutzer bedienbar ist, wobei das Gehäuseteil derart in einer Ausnehmung (9;23;53;104;203;303) des Gehäuses (7;21;51;101;201;301) des Gerätes montiert ist, daß es in Bezug auf das Gehäuse aus einer ersten, geschlossenen Stellung in eine zweite, geöffnete Stellung drehbar ist, in der die Steuereinheit aus dem Gehäuseteil entnehmbar ist, dadurch gekennzeichnet, daß nur in der zweiten, geöffneten Stellung des Gehäuseteils die darin aufgenommene Steuereinheit für den Benutzer zugänglich und zur Steuerung des Fernsehempfängers bedienbar ist.

2. Steuergerät nach Anspruch 1, bei dem die Steuereinheit einen Steuersignalsender (14) aufweist und ein Steuersignalempfänger (16) in Inneren des Gehäuses montiert ist, und bei dem das Gehäuseteil rohrförmige Signalreflektormittel (15,17,18) aufweist, die dazu eingerichtet sind, in der geöffneten Stellung des Gehäuseteils das Steuersignal, das von der in dem Gehäuseteil untergebrachten Steuereinheit ausgesandt wird, auf den Steuersignalempfänger zu lenken.

3. Steuergerät nach Anspruch 1 oder 2, bei dem Verriegelungsmittel (56,59,66,70,71) zur lösbaren Verriegelung des Gehäuseteils in der geschlossenen Stellung vorgesehen sind, wobei die Verriegelungsmittel einen Schieber (59), der durch elastisch Mittel mit Halteeinrichtungen (76) an dem Gehäuseteil in Eingriff gehalten wird, und Entriegelungsmittel (70,71) aufweisen, durch die der Schieber entgegen der Vorspannung bewegbar ist, um den Eingriff des Schiebers mit der Halteeinrichtung zu lösen.

4. Steuergerät nach Anspruch 3, bei dem die Entriegelungsmittel einen Stift (70) aufweisen, der einen manuell von außerhalb des Gehäuses betätigbaren ersten Abschnitt (74) und einen zweiten Abschnitt (69) mit einer geneigten Oberfläche besitzt, die an einem Rand einer in dem Schieber gebildeten und von dem Stift durchlaufenden Öffnung (60) anliegt, so daß die axiale Bewegung des Stiftes bei manueller Betätigung des ersten Abschnitts ein Aufgleiten der geneigten Oberfläche auf den Rand der Öffnung bewirkt, um den Schieber entgegen der Vorspannung zu bewegen.

5. Steuergerät nach Anspruch 1 oder 2, bei dem Verriegelungsmittel (56,59,66,70,71;113,118, 120,121) zur lösbaren Verriegelung des Gehäuseteils in der geschlossenen Stellung vorgesehen sind, wobei die Verriegelungsmittel ein Eingriffsglied (59;120) für den Eingriff mit dem Gehäuseteil und einen Stift (70;113) aufweisen, der durch elastische Mittel so vorgespannt ist, daß er das Eingriffsglied berührt und mit dem Gehäuseteil in Berührung hält, und wobei außerdem Mittel (80;122) zum Drehen des Gehäuseteils in die geöffnete Stellung, nachdem der Eingriff des Eingriffsgliedes durch Bewegen des Stiftes gelöst wurde, und Haltemittel (76;124) zum Halten des Gehäuseteils in der geöffneten Stellung vorgesehen sind.

6. Steuergerät nach Anspruch 5, bei dem der Stift (113) einen manuell von außerhalb des Gehäuses betätigbaren ersten Abschnitt (115) und einen zweiten Abschnitt mit einer Ausnehmung (111) aufweist, die in einer solchen Position ausgebildet ist, daß bei axialer Bewegung des Stiftes durch manuelle Betätigung des ersten Abschnitts das Eingriffsglied (120) derart bewegt wird, daß es in die Ausnehmung eintritt und dadurch die Freigabe des Gehäuseteils aus der geschlossenen Stellung bewirkt.

7. Steuergerät nach Anspruch 1 oder 2, bei dem Mittel (30,42,43;113,120;209,217,218;308,310, 312) zur lösbaren Verriegelung des Gehäuseteils in der geschlossenen Stellung vorgesehen sind, wobei die Verriegelungsmittel ein drehbar in dem Gehäuse montiertes Verriegelungsglied (30; 120;209;308) und Mittel (42,43;113;217, 218;310,312) zur Steuerung der Drehbewegung des Verriegelungsgliedes aufweisen, und wobei Haltemittel (37;124;224;319) vorgesehen sind, die das Gehäuseteil in seiner geöffneten Stellung halten, wenn es durch das Verriegelungsglied freigegeben wurde.

8. Steuergerät nach Anspruch 7, bei dem die Mittel zur Steuerung ein erstes bewegbares Element (218), das manuell von außerhalb des Gehäuses betätigbar ist, und ein zweites, schwenkbares Element (217) aufweisen, das mit dem drehbaren Verriegelungsglied (209) und dem ersten beweglichen Element in Berührung steht, wobei das Verschwenken des zweiten Elements durch manuelle Betätigung des ersten Elements eine Drehung des Verriegelungsgliedes außer Eingriff mit einem Vorsprung (224) an dem Gehäuseteil (202) bewirkt.

9. Steuergerät nach Anspruch 7, bei dem die Mittel zur Steuerung durch eine durch manuellen Druck auf die vordere Oberfläche des Gehäuseteils bewirkte Drehung des Gehäuseteils betätigbar sind, um die Freigabe des Gehäuseteils (302) aus der geschlossenen Stellung durch das Verriegelungsglied (308) zu veranlassen.

10. Steuergerät nach Anspruch 9, bei dem die Mittel zur Steuerung einen an dem Verriegelungsglied vorgesehenen Nocken (310), einen Nockenfolgerstift (312), der in einen in dem Nocken ausgebildeten geschlossenen Kulissenschlitz (311) eingreift, und Feder-Spannmittel (314) umfassen, die das Verriegelungsglied in der geschlossenen Stellung des Gehäuseteils mit diesem in Eingriff halten, wobei der Kulissenschlitz erste und zweite Anlageflächen (313', 313) für den Nockenfolger aufweist und das Verriegelungsglied in seiner Stellung zur Verriegelung des Gehäuseteils in der Schließstellung gehalten wird, wenn der Nockenfolger an der ersten Anlagefläche (313') anliegt, und wobei die Drehung des Verriegelungsgliedes entgegen der Federkraft infolge der Drehbewegung des Gehäuseteils aufgrund des manuell auf dessen vordere Oberfläche ausgeübten Druckes die Bewegung des Nockenfolgers von der ersten Anlagefläche in Richtung auf die zweite Anlagefläche des Kulissenschlitzes bewirkt und die Anlage des Nockens an der zweiten Anlagefläche (313) das Verriegelungsglied in einer nicht verriegelnden Stellung hält, in der die Drehung des Gehäuseteils (302) in die geöffnete Stellung möglich ist, nachdem der manuelle Druck auf das Gehäuseteil aufgehoben wurde.

11. Steuergerät nach irgendeinem der vorstehenden Ansprüche, mit Feder-Vorspannmitteln (40;80;122;227;324) zum Vorspannen des Gehäuseteils im Sinne einer Schwenkbewegung in Richtung auf seine geöffnete Stellung.

12. Steuergerät nach irgendeinem der vorstehenden Ansprüche, bei dem das elektronische Gerät ein Fernsehempfänger ist.

**Revendications**

1. Dispositif de commande électronique installé dans un appareil tel qu'un poste de télévision ou un enregistreur vidéo, dans lequel un élément de logement (8;22;52;103;202;302) loge une unité de commande (12), qui peut être actionnée par un utilisateur afin de commander l'appareil, l'élément, de logement étant monté dans un renfoncement (9;23;53;104;203;303) du boîtier (7;21;51;101;201;301) de l'appareil de sorte qu'on peut le faire tourner par rapport au boîtier pour l'amener depuis une première position fermée dans une seconde position ouverte, dans laquelle l'unité de commande peut être retirée de l'élément de logement, caractérisé en ce que c'est uniquement lorsque l'élément de logement est dans ladite seconde position ouverte que l'unité de commande, qui s'y trouve logée, est présentée de manière que l'utilisateur puisse y avoir accès et peut être actionnée pour la commande du poste de télévision.

2. Dispositif de commande selon la revendication 1, dans lequel ladite unité de commande comprend un émetteur (14) de signaux de commande, et dans lequel un récepteur (16) des signaux de commande est monté à l'intérieur dudit boîtier, ledit élément de logement incluant des moyens (15,17,18) réfléchissant les signaux et possédant une forme tubulaire adaptée pour diriger ledit signal de commande émis par ladite unité de commande logée dans ledit élément de logement vers ledit récepteur de signaux de commande lorsque l'élément de logement est dans ladite position ouverte.

3. Dispositif de commande selon la revendication 1 ou 2, dans lequel des moyens (56,59,66,70,71) sont prévus pour verrouiller de façon amovible ledit élément de logement dans ladite position fermée, lesdits moyens de verrouillage incluant un élément coulissant (59) sollicité par des moyens élastiques de manière à s'engager avec des moyens de butée (76) situés sur l'élément de logement, et des moyens (70,71) de libération du verrouillage, servant à déplacer ledit élément à l'encontre de la sollicitation de manière à supprimer l'engagement entre ledit élément coulissant et lesdits moyens de butée.

4. Dispositif de commande selon la revendication 3, dans lequel lesdits moyens de libération du verrouillage incluant un élément en forme de tige (70) possédant une première partie (74) pouvant être actionnée manuellement à partir de l'extérieur du boîtier, une seconde partie (69) incluant une surface inclinée qui vient en contact contre un bord d'une ouverture (60) ménagée dans l'élément coulissant et dans laquelle s'engage ledit élément en forme de tige, le déplacement axial dudit élément en forme de tige au moyen de l'actionnement manuel de ladite première partie amenant la surface inclinée à glisser sur ledit bord de l'ouverture, ce qui provoque un déplacement de l'élément coulissant à l'encontre de ladite sollicitation.

5. Dispositif de commande selon la revendication 1 ou 2, dans lequel des moyens (56,59,66,70,71;113,118,120,121) sont prévus de manière à verrouiller de façon amovible ledit élément de logement dans ladite position fermée, lesdits moyens de verrouillage incluant un organe d'engrènement (59;120) servant à engrener avec ledit élément de logement, et un élément en forme de tige (70;113) sollicité par lesdits moyens élastiques pour engrener avec ledit organe d'engrènement, et dans lequel il est également prévu des moyens (80;122) servant à faire tourner l'élément de logement lorsqu'il est libéré de son engrènement avec ledit organe d'engrènement lors du déplacement dudit élément en forme de tige, en direction de ladite position ouverte, et des moyens de butée (76;124) servant à retenir ledit élément de logement dans ladite position ouverte.

6. Dispositif de commande selon la revendication 5, dans lequel ledit élément en forme de tige (113) possède une première partie (104) pouvant être actionnée manuellement à partir de l'extérieur dudit logement, et une seconde partie incluant un renfoncement (111) ménagé dans une position telle que lors du déplacement axial de l'élément en forme de tige sous l'effet de l'actionnement manuel de la première partie, l'organe d'engrènement (120) est amené à se déplacer de manière à pénétrer dans ledit renfoncement, ce qui provoque la libération dudit élément de logement à partir de ladite position fermée.

7. Dispositif de commande selon la revendication 1 ou 2, dans lequel des moyens (30,42,43;113,120;209,217,218;308,310,312) sont prévus de manière à verrouiller de façon amovible ledit élément de logement dans ladite position fermée, lesdits moyens de verrouillage incluant un organe de blocage (30;120;209;308) monté rotatif dans ledit boîtier, et des moyens (42,43;113;217,218;310,312) servant à commander la rotation dudit organe de blocage, et dans lequel des moyens de butée (37;104;224;319) sont prévus pour retenir ledit élément de logement dans sa position ouverte lorsqu'il est libéré par ledit organe de blocage.

8. Dispositif de commande selon la revendication 7, dans lequel lesdits moyens de commande comprennent un premier organe déplaçable (218) pouvant être actionné manuellement à partir de l'extérieur du boîtier, et un second organe pivotant (217) engrenant avec ledit organe de blocage rotatif (209) et avec ledit premier organe déplaçable, un pivotement dudit second organe au moyen de l'actionnement manuel dudit premier organe amenant l'organe de blocage à se dégager, par pivotement, d'un organe saillant (224) présent sur ledit élément de logement (202).

9. Dispositif de commande selon la revendication 7, dans lequel lesdits moyens de commande doivent être actionnés en vue d'amener l'organe de blocage (308) à libérer l'élément de logement (302) de sa position fermée, en réponse à un mouvement de rotation dudit élément de logement, provoqué par une pression manuelle appliquée sur la surface frontale de cet élément.

10. Dispositif de commande selon la revendication 9, dans lequel lesdits moyens de commande comprennent une came (310) prévue sur ledit organe de blocage, un téton suiveur de came (312) s'engage dans une fente fermée (311) ménagée dans ladite came, et des moyens de sollicitation en forme de ressort (311) repoussant ledit organe de blocage de manière qu'il soit en contact avec l'élément de logement lorsque ce dernier est dans sa position fermée, ladite fente de la came comportant des première et seconde parties (313',313) d'engagement du suiveur de came, l'engagement dudit suiveur de came dans ladite première partie d'engrènement (313) maintenant l'organe de blocage dans sa position de manière à verrouiller l'élément de logement dans sa position fermée, et dans lequel une rotation dudit organe de blocage à l'encontre de la sollicitation du ressort lors dudit mouvement de rotation de l'élément de logement sous l'action de ladite pression manuelle appliquée à ladite surface frontale de cet élément de logement provoque un déplacement du suiveur de came depuis ladite première position d'engrènement vers ladite seconde position d'engrènement de ladite fente de la came, l'engrènement de ladite came dans ladite seconde partie d'engrènement (313) maintenant ledit organe de blocage dans une position ne réalisant pas un verrouillage afin de permettre la rotation dudit élément de logement (302) vers la position ouverte, lors du relâchement de ladite pression manuelle.

11. Dispositif de commande selon l'une quelconque des revendications précédentes, incluant des moyens de sollicitation en forme de ressort (40;80;122;227;324) agencés de manière à solliciter ledit élément de logement en rotation en direction de ladite position ouverte.

12. Dispositif de commande selon l'une quelconque des revendications précédentes, dans lequel l'appareil électronique est un poste de télévision.

FIG. 1

FIG. 2

FIG.3

FIG.4

EP 0 088 611 B1

FIG.5

FIG.6

FIG.7

FIG.8

FIG.9

FIG.10

FIG.11

FIG.12

## FIG.13

## FIG.14

## FIG.15

4

## FIG.16

## FIG.17

## FIG.19

## FIG.18

# FIG. 20

# FIG.21

# FIG.22

# FIG.23

# FIG.24